# EUROPEAN PATENT APPLICATION

(11) **EP 1 544 850 A2**
(43) Date of publication of application: **22.06.2005**
(21) Application number: 04016730.6
(22) Date of filing: 15.07.2004
(51) Int. Cl.: G11B 7/0065, G03H 1/04

(54) **Holographic rom memory**

(30) Priority: 15.12.2003 KR 2003091278
(71) Applicant: Daewoo Electronics Corporation, Seoul (KR)
(72) Inventor: Kim, Kun Yul, Mapo-gu Seoul (KR)
(74) Representative: Jacoby, Georg, Dr.

(57) **Abstract**

In a system for holographically recording ROM data in a holographic medium (122), a data mask (124) modulates a signal beam (51) with the data to generate a modulated signal beam to interfere with a reference beam (52) introduced in the holographic medium, the signal beam and the reference beam having similar linear polarisation. In the system, a portion of the reference beam transmitted through the holographic medium is subsequently reflected to generate a reflected reference beam that propagates back to the holographic medium. Further, a beam polarizer (128) causes a polarization of said reflected reference beam to be changed so that the polarization thereof is different from that of the reference beam and the modulated signal beam, to thereby prevent the reflected reference beam from interfering with the reference beam and the modulated signal beam.

## Description

The present invention relates to a holographic ROM system; and, more particularly, to a holographic ROM system capable of preventing a noise component from being recorded in a holographic medium when recording data therein, the noise component being produced due to an interference of a reflected reference beam generated by reflecting a reference beam against a data mask with the reference beam and/or a modulated signal beam.

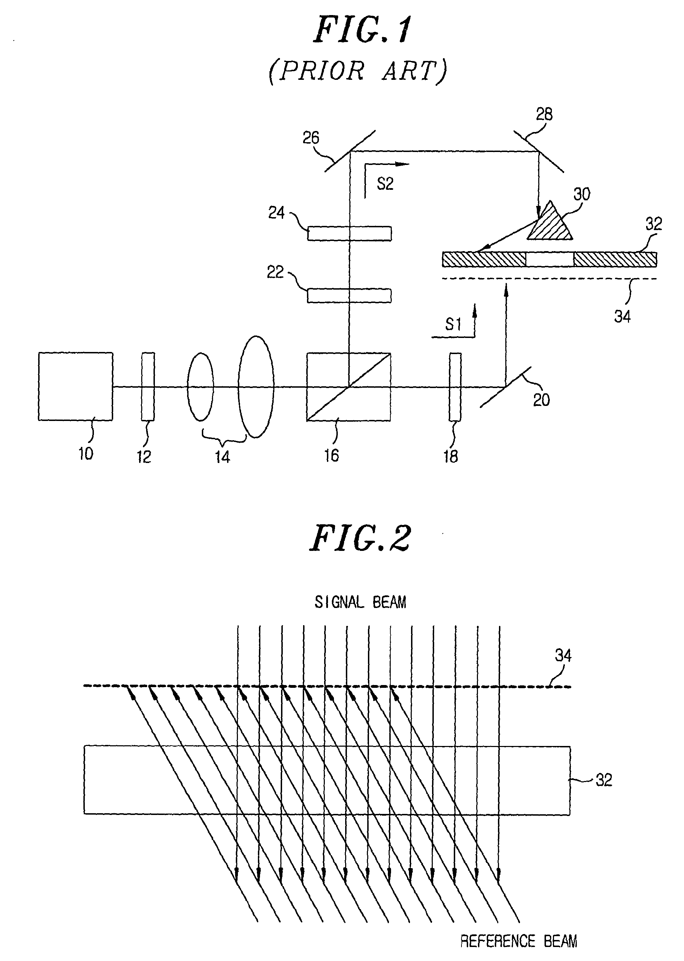

Fig. 1 shows a configuration of a conventional holographic ROM system. As shown in Fig. 1, the conventional holographic ROM system includes a light source 10, HWPs (half wave plates) 12 and 22, a beam expander 14, a PBS (polarized beam splitter) 16, polarizers 18 and 24, mirrors 20, 26 and 28, a conical mirror 30, a holographic medium 32 and a data mask 34.

The light source 10 emits a laser beam with a wavelength of, e.g., 532 nm. The laser beam, which is of only one type of linear polarization, e.g., P-polarization or S-polarization, is provided to the HWP 12. The HWP 12 rotates the polarization of the laser beam by θ degree (preferably 45°). And then, the polarization-rotated laser beam is provided to the beam expander 14 for expanding the beam size of the laser beam up to a predetermined size. Thereafter, the expanded laser beam is provided to the PBS 16.

The PBS 16, which is manufactured by repeatedly depositing at least two kinds of materials each having a different refractive index, serves to transmit, e.g., a horizontally polarized laser beam, i.e., S-polarized beam, along a S1 path and reflect, e.g., a vertically polarized laser beam, i.e., P-polarized beam, along a S2 path. Thus the PBS 16 divides the expanded laser beam into a transmitted laser beam (hereinafter, referred to as "reference beam") and a reflected laser beam (hereinafter, referred to as "signal beam") having different polarizations, respectively.

The signal beam, e.g., of a S-polarization, is provided to the mirror 20 via the polarizer 18. Herein, the polarizer 18 serves to pass only an S-polarized signal beam. The S-polarized signal beam is reflected by the mirror 20 and then projected onto the data mask 34. The data mask 34, presenting a predetermined data pattern to be recorded in the holographic medium 32, functions as an input device, e.g., a spatial light modulator (SLM). The signal beam is modulated by the data pattern of the data mask 34 so that a modulated signal beam is propagated toward the holographic medium 32.

Meanwhile, the reference beam is fed to the mirror 26 via the HWP 22 and the polarizer 24 sequentially. Since the HWP 22 can rotate the polarization of the reference beam by θ degree and the polarizer 24 serves to pass only an S-polarized reference beam, the HWP 22 and the polarizer 24 can regulate the amount of the S-polarized reference beam arriving at the mirror 26 by changing θ. Therefore, the polarization of the reference beam becomes identical to that of the modulated signal. beam. Next, the S-polarized reference beam is reflected by the mirror 28 and then projected onto the conical mirror 30 fixed by a holder (not shown), wherein the conical mirror 30 is of a circular cone having a circular base with a preset base angle between the circular base and the cone. The conical mirror 30 reflects the reference beam conically toward the holographic medium 32. The incident angle of the reference beam incident on the holographic medium 32 is determined by the base angle of the conical mirror 30.

Fig. 2 shows a holographic medium wherein data patterns are recorded by employing the conventional holographic ROM system. As shown in Fig. 2, the holographic medium 32 is a disk-shaped material for recording certain data patterns. The data mask 34 provides the data patterns to be stored in the holographic medium 32. By illuminating one side of the holographic medium 32 with the modulated signal beam perpendicular to the data mask 34 and the opposite side thereof with the reference beam, an interference pattern generated due to an interference of the reference beam with the modulated signal beam is recorded in the holographic medium 32. Meanwhile, the holographic ROM system may perform an angular multiplexing by exchanging the conical mirror 30 with another conical mirror having a different reflection angle and then providing the reference beam and the modulated signal beam along the aforementioned paths to thereby record another data pattern in the holographic medium 32.

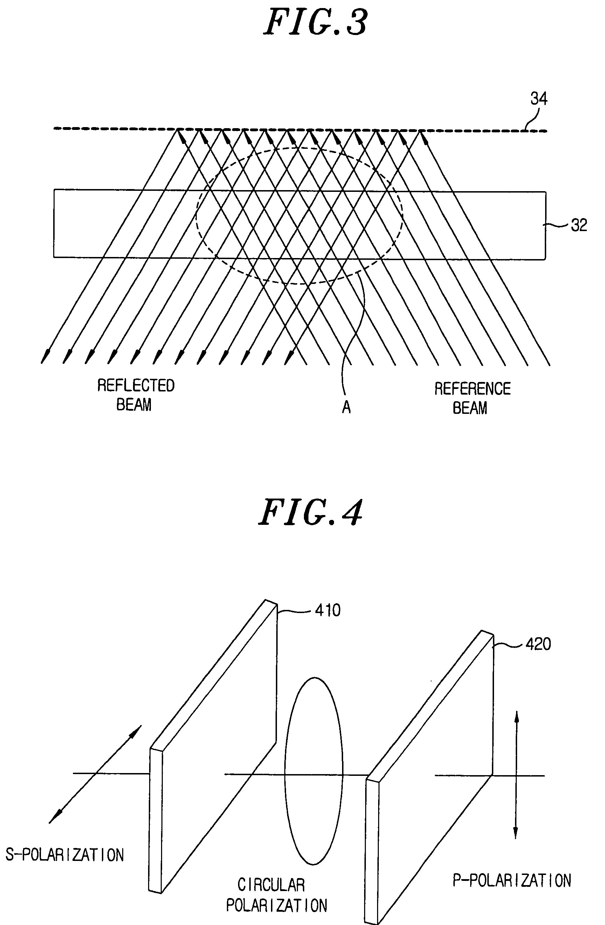

However, as shown in Fig. 3, in the conventional holographic ROM system, a transmitted reference beam generated from a transmission of a portion of the reference beam entering a holographic medium 32 is reflected by the data mask 34 so that a reflected reference beam thereof is generated. The reflected reference beam is reentered into the holographic medium 32. Accordingly, an interference pattern produced due to an interference of the reflected reference beam with the reference beam and/or the modulated signal beam as well as that produced due to an interference of the reference beam with the modulated signal beam, i.e., a noise component A is recorded in the holographic medium 32.

It is, therefore, an object of the present invention to provide a holographic ROM system capable of preventing a noise component produced due to an interference of a reflected reference beam generated by reflecting a reference beam against a data mask with the reference beam and/or a modulated signal beam from being recorded in a holographic medium by modifying a polarization of the reflected reference beam to be perpendicular to those of the reference beam and/or the modulated signal beam.

In accordance with the present invention, there is provided a holographic ROM system for recording data in a holographic medium, the holographic ROM system comprising:
a data mask for modulating a signal beam with the data to generate a modulated signal beam to interfere with a reference beam introduced in the holographic medium and reflecting a transmitted reference beam, generated from a transmission of a portion of the reference beam through the holographic medium, to generate a reflected reference beam to be propagated toward the holographic medium; and
a beam polarization changer for changing a polarization of the reflected reference beam so that the polarization thereof is different from those of the reference beam and the modulated signal beam, to thereby prevent the reflected reference beam from interfering with the reference beam and the modulated signal beam.

The above and other objects and features of the present invention will become apparent from the following description of preferred embodiments, given in conjunction with the accompanying drawings, in which:
Fig. 1 shows a diagram of a conventional holographic ROM system;
Fig. 2 illustrates a diagram for explaining a process in which a data pattern is recorded by employing the conventional holographic ROM system;
Fig. 3 provides a diagram for describing a process in which a noise component is generated during a data recording process of the conventional holographic ROM system;
Fig. 4 depicts a diagram for explaining a process for changing a polarization of a linear polarized beam in accordance with the present invention;
Fig. 5 describes a diagram for depicting a data recording process employing a holographic ROM system in accordance with a preferred embodiment of the present invention; and
Fig. 6 presents a diagram of a holographic ROM system in accordance with a preferred embodiment of the present invention.

Fig. 4 illustrates a process for transforming a horizontally polarized beam (or a vertically polarized beam) into a vertically polarized beam (or a horizontally polarized beam) by using two quarter wave plates (QWPs). As shown in Fig. 4, in case a linear polarized beam enters a QWP 410, the linear polarized beam is transformed into a circular polarized beam. Further, in case a P circular polarized beam and an S circular polarized beam enter another QWP 420, the P circular polarized beam and the S circular polarized beam are transformed into an S linear polarized beam and a P linear polarized beam, respectively. In the result, the linear polarized beam (P linear-polarized beam) transformed by the QWP 420 is perpendicular to the linear polarized beam (S linear-polarized beam) entering the QWP 410.

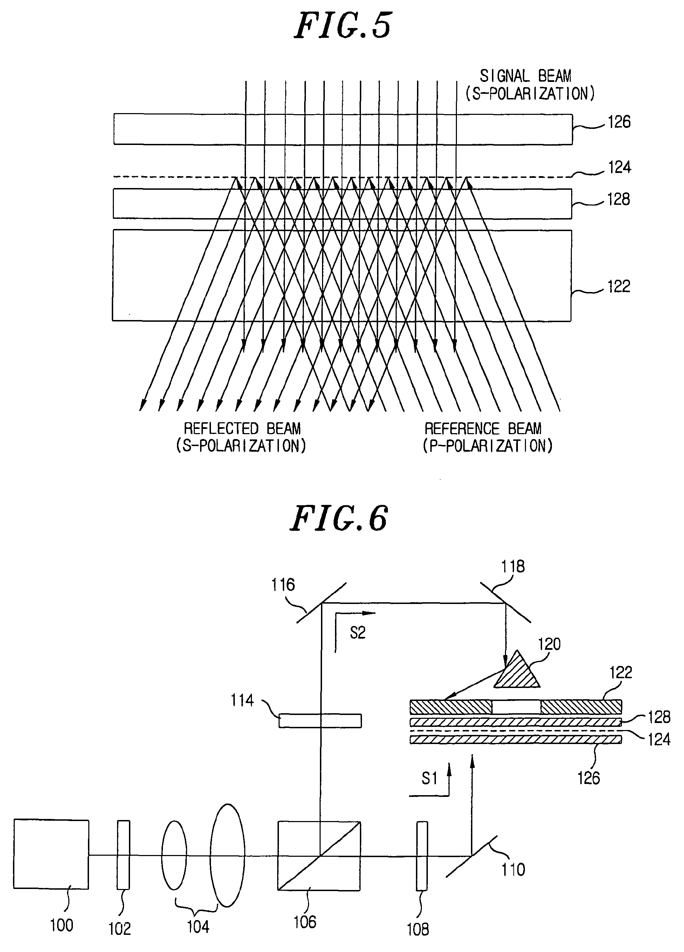

The present invention employs such a transforming principal of the linear polarized beam by the QWP. In other words, as illustrated in Fig. 5, two QWPs 126 and 128 are installed at both sides of a data mask 124 for generating a data pattern to be recorded into a holographic medium 122. Accordingly, if a P linear-polarized beam as a reference beam enters a lower surface of the holographic medium 122, a portion of the reference beam is transmitted through the holographic medium 122 to generate a transmitted reference beam. The transmitted reference beam is transmitted through the QWP 128 so that the transmitted reference beam is changed to a P circular-polarized beam. After the transmitted reference beam is reflected by the data mask 124 to be a reflected reference beam, the reflected reference beam is transmitted again through the QWP 128 so that the reflected reference beam is changed to an S linear-polarized beam. Thus, a polarization of the reflected reference beam becomes an S linear polarization that is perpendicular to that of the reference beam which has a P linear polarization.

In the meantime, an S linear-polarized beam as a signal beam enters an upper surface of the QWP 126. In this case, the signal beam is transmitted through the QWP 126 so that the signal beam is changed to an S circular-polarized beam. The signal beam is modulated with data in the data mask 124 to generate a modulated signal beam. The modulated signal beam is transmitted through the QWP 128 so that the modulated signal beam is changed to a P linear-polarized beam. The modulated signal beam is propagated toward the holographic medium 122. Since, however, the reflected reference beam (the S linear-polarized beam) do not interfere with the modulated signal beam (the P linear-polarized beam) or the reference beam (the P linear-polarized beam), the reference beam incident on the holographic medium 122 interferes with the modulated signal beam having a polarization identical to that of the reference beam, but not with the reflected reference beam having a polarization perpendicular to that of the reference beam. Accordingly, contrary to the conventional holographic system described with reference to Fig. 3, it is possible to avoid a noise generated due to the interference of the reflected reference beam with the reference beam.

Fig. 6 provides a structure of a holographic ROM system in accordance with a preferred embodiment of the present invention, the holographic ROM system employing a transforming principal of the polarization direction of a linear polarized beam, which is described with reference to Figs. 4 and 5. As illustrated in Fig. 6, the holographic ROM system in accordance with the preferred embodiment of the present invention includes a light source 100, a HWP (half wave plate) 102, a beam expander 104, a PBS (polarized beam splitter) 106, polarizers 108 and 114, mirrors 110, 116 and 118, a conical mirror 120, a holographic medium 122, a data mask 124 and a first and a second QWPs 126 and 128.

The light source 100 emits a laser beam with a wavelength of, e.g., 532 nm. The laser beam, which is of only one type of linear polarization, e.g., P-polarization or S-polarization, is provided to the HWP 102. The HWP 102 rotates the polarization of the laser beam by θ degree (preferably 45°). And then, the polarization-rotated laser beam is provided to the beam expander 104 for expanding the beam size of the laser beam up to a predetermined size. Thereafter, the expanded laser beam is provided to the PBS 106.

The PBS 106, which is manufactured by repeatedly depositing at least two kinds of materials each having a different refractive index, serves to transmit, e.g., a horizontally polarized laser beam, i.e., S linear-polarized beam, along a S1 path and reflect, e.g., a vertically polarized laser beam, i.e., P linear-polarized beam, along a S2 path. Thus the PBS 106 divides the expanded laser beam into a transmitted laser beam (hereinafter, referred to as "reference beam") and a reflected laser beam (hereinafter, referred to as "signal beam") having different polarizations, respectively.

The signal beam, e.g., of an S linear-polarization, is provided to the mirror 110 via the polarizer 108. Herein, the polarizer 108 serves to pass only an S linear-polarized signal beam. The S linear-polarized signal beam is reflected by the mirror 110 and then projected onto the holographic medium 122 via the first and the second QWP 126 and 128 and the data mask 124. In this case, since the signal beam modulated by the data mask 124 as a modulated signal beam passes the first and the second QWP 126 and 128, the polarization direction of the modulated signal beam is changed from the S linear polarization to the P linear polarization. Therefore, the P linear-polarized modulated signal beam enters the holographic medium 22.

Meanwhile, the reference beam is fed to the mirror 116 via the polarizer 114. Herein, a polarization of the reference beam is the P linear-polarized beam that is opposite to that of the signal beam. Thereafter, the P linear-polarized reference beam is reflected by the mirror 118 and then projected onto the conical mirror 120 fixed by a holder (not shown), wherein the conical mirror 120 is of a circular cone having a circular base with a preset base angle between the circular base and the cone. The conical mirror 120 reflects the reference beam toward the holographic medium 122. The incident angle of the reflected reference beam incident on the holographic medium 122 is determined by the base angle of the conical mirror 120.

The modulated signal beam and the reference beam have the same polarization direction (P linear-polarization), so that an interference pattern generated by the interference therebetween is recorded in the holographic medium 122. Since, however, the reflected reference beam produced by a reflection of the reference beam against the data mask 124 passes again the second QWP 128, the polarization direction thereof is changed into the S linear-polarized beam. Accordingly, the reflected reference beam does not interfere with the reference beam that initially entered the holographic medium 122. As a result, it is possible to prevent a noise generated due to the interference of the reflected reference beam with the reference beam from being recorded therein as in the conventional holographic ROM system.

Meanwhile, the holographic ROM system may perform an angular multiplexing by exchanging the conical mirror 120 with another conical mirror having a different reflection angle and then providing the reference beam and the modulated signal beam along the aforementioned paths to thereby record another data pattern in the holographic medium 122.

As described above, in accordance with the present invention, a noise can be prevented from being recorded in a holographic medium by modifying a polarization of a reflected reference beam to be perpendicular to that of a reference beam by using a QWP, the reflected reference beam being produced by a reflection of the reference beam entering the holographic medium against a data mask.

While the invention has been shown and described with respect to the preferred embodiments, it will be understood by those skilled in the art that various changes and modifications may be made without departing from the scope of the invention as defined in the following claims.

## Claims

1. A holographic ROM system for recording data in a holographic medium, the holographic ROM system comprising:
a data mask for modulating a signal beam with the data to generate a modulated signal beam to interfere with a reference beam introduced in the holographic medium and reflecting a transmitted reference beam, generated from a transmission of a portion of the reference beam through the holographic medium, to generate a reflected reference beam to be propagated toward the holographic medium; and
a beam polarization changer for changing a polarization of the reflected reference beam so that the polarization thereof is different from those of the reference beam and the modulated signal beam, to thereby prevent the reflected reference beam from interfering with the reference beam and the modulated signal beam.

2. The holographic ROM system of claim 1, wherein the polarization of the reflected reference beam to be propagated toward the holographic medium is substantially perpendicular to those of the reference beam and the modulated signal beam.

3. The holographic ROM system of claim 1, wherein the beam polarization changer includes a wave plate, located between the data mask and the holographic medium, for converting each polarization of the reflected reference beam and the modulated signal beam from an S linear polarization, an S circular polarization, a P linear polarization and/or a P circular polarization to the S circular polarization, the P linear polarization, the P circular polarization and/or the S linear polarization, respectively.

4. The holographic ROM system of claim 3, wherein the wave plate is a quarter wave plate.

5. The holographic ROM system of claim 3, wherein the beam polarization changer further includes another wave plate for converting a polarization of the signal beam from the S linear polarization, the S circular polarization, the P linear polarization and/or the P circular polarization to the S circular polarization, the P linear polarization, the P circular polarization and/or the S linear polarization, respectively.

6. The holographic ROM system of claim 5, wherein said another wave plate is a quarter wave plate.
